(19) **Europäisches Patentamt / European Patent Office / Office européen des brevets**

(11) **EP 4 647 879 A2**

(12) **EUROPEAN PATENT APPLICATION**
published in accordance with Art. 153(4) EPC

(43) Date of publication:
**12.11.2025 Bulletin 2025/46**

(21) Application number: **23915038.6**

(22) Date of filing: **19.12.2023**

(51) International Patent Classification (IPC):
**G06F 3/0354** (2013.01)    **G01R 27/26** (2006.01)
**G01R 23/02** (2006.01)

(52) Cooperative Patent Classification (CPC):
**G01R 23/02; G01R 27/26; G06F 3/0354**

(86) International application number:
**PCT/KR2023/095126**

(87) International publication number:
**WO 2024/147579 (11.07.2024 Gazette 2024/28)**

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**
Designated Extension States:
**BA**
Designated Validation States:
**KH MA MD TN**

(30) Priority: **05.01.2023 KR 20230001969**

(71) Applicant: **Hideep Inc.**
**Seongnam-si, Gyeonggi-do 13493 (KR)**

(72) Inventors:
• **MOON, Ho Jun**
**Seongnam-si, Gyeonggi-do 13493 (KR)**
• **KIM, Kiung**
**Seongnam-si, Gyeonggi-do 13493 (KR)**
• **BYUN, Mun Sub**
**Seongnam-si, Gyeonggi-do 13493 (KR)**
• **KIM, Seyeob**
**Seongnam-si, Gyeonggi-do 13493 (KR)**

(74) Representative: **HGF**
**HGF Europe LLP**
**Neumarkter Straße 18**
**81673 München (DE)**

(54) **STYLUS PEN**

(57)    The present invention relates to a stylus pen, and more particularly, to a stylus pen that is capable of clearly distinguishing a hover motion, a contact motion and a pen pressure motion, has a simple internal structure, easily detects pen pressure, has relatively little performance change caused by an assembly deviation, and reduces manufacturing costs. The stylus pen according to an embodiment of the present invention comprises: an inductor unit; a first elastic member disposed to be spaced from the inductor unit; a core which is disposed to penetrate the inductor unit, and which moves toward the first elastic member by means of an external force acting on one end thereof; and a magnetic body which is disposed between the inductor unit and the first elastic member, and of which the distance from the inductor unit changes in conjunction with that of the core, wherein the first elastic member is compressed by the movement of the core.

FIG. 1

## Description

## TECHNICAL FIELD

The present invention relates to a stylus pen, and more particularly, to a stylus pen that is capable of clearly distinguishing a hover motion, a contact motion and a pen pressure motion, has a simple internal structure, easily detects pen pressure, has relatively little performance change caused by an assembly deviation, and is capable of reducing manufacturing costs.

## BACKGROUND ART

A stylus pen is a pen-shaped device capable of inputting data by lightly touching a screen while dragging or clicking on the screen. A user may use the stylus pen for a precise touch input.

The stylus pen may be classified into an active stylus pen and a passive stylus pen depending on whether the stylus pen includes a battery and an electronic component therein.

Although the active stylus pen has an advantage of having an excellent basic performance and providing additional functions (pen pressure, hovering, and buttons) in comparison with the passive stylus pen, the active stylus pen has a disadvantage in that most of users substantially do not use the active stylus pen except for some advanced users because the active stylus pen is expensive and uses a rechargeable battery as power.

Although the passive stylus pen has an advantage in that the passive stylus pen is inexpensive and does not require a battery in comparison with the active stylus pen, the passive stylus pen has a disadvantage in that the passive stylus pen is difficult to recognize a precise touch in comparison with the active stylus pen. In recent years, however, technologies of an electro magnetic resonance (EMR) method that is an inductive resonance method and a capacitive resonance method are proposed to realize a passive stylus pen capable of recognizing a precise touch.

Although the EMR method is excellent in writing and drawing quality that is a key function of the stylus pen, the EMR method has a disadvantage of having a great thickness and requiring more costs because a separate EMR sensor panel and a separate EMR driving IC are necessarily added in addition to a capacitance touch panel.

The capacitive resonance method uses a general capacitance touch sensor and a general touch controller IC to increase a performance of the IC and support a pen touch without additional costs.

In the EMR method or the capacitive resonance method, a resonance signal is required to have a great amplitude to more accurately distinguish a touch caused by the stylus pen. Thus, a driving signal transmitted to the stylus pen needs to have the almost same resonance frequency as that of the resonance circuit contained in the stylus pen. However, according to a conventional EMR or capacitive resonance method, although the resonance frequency is the same as a frequency of the driving signal, signal transmission is difficult because of extremely great attenuation of the signal transmission. As a result, despite a lot of attempts of many touch controller IC vendors for a long time, no companies have succeeded in mass production because a sufficient output signal is not produced.

Thus, a feature of how to design structures of an inner resonance circuit and a pen is a key factor to manufacture an EMR or capacitive resonance stylus pen capable of producing a maximum output signal.

In case of an electro-magnetic resonance (EMR) pen among the passive stylus pens, a digitizer transmits an electromagnetic signal to the pen and then receives a resonance signal from the pen. In this digitizer, coils to which a current is induced by a magnetic signal are densely arranged to receive touch information by the pen, The digitizer may not correspond to miniaturization and thinness of the touch input device and may not be flexibly designed.

On the other hand, a conventional stylus pen requires an expensive pressure sensor to detect pen pressure and is difficult to measure precise pen pressure.

## DISCLOSURE OF THE INVENTION

## TECHNICAL PROBLEM

The present invention provides a stylus pen capable of clearly distinguishing various motions, e.g., a hover motion, a contact motion, and a pen pressure motion.

The present invention also provides a stylus pen capable of decreasing the number of inner components to reduce manufacturing costs.

The present invention also provides a stylus pen having a relatively small performance variation caused by an assembly deviation of inner components.

## TECHNICAL SOLUTION

An embodiment of the present invention provide a stylus pen including: an inductor unit; a first elastic member spaced apart from the inductor unit; a core that passes through the inductor unit and moves toward the first elastic member by an external force acting on one end thereof; and a magnetic body disposed between the inductor unit and the first elastic member. Here, a distance between the magnetic body and the inductor unit is varied based on a movement of the core, and the first elastic member is compressed by the movement of the core.

In an embodiment, the first elastic member may be a spring.

In an embodiment, the first elastic member may be disposed in a state in which at least a portion thereof is compressed.

In an embodiment, the stylus pen may further include a second elastic member that surrounds a portion of the first elastic member and is compressed by the movement of the core, in which the second elastic member is made of a rubber material or is a spring.

In an embodiment, the first elastic member may be made of a rubber material.

In an embodiment, the stylus pen may further include a second elastic member that surrounds a portion of the first elastic member and is compressed by the movement of the core, in which the second elastic member is made of the rubber material that is relatively harder than that of the first elastic member.

In an embodiment, the stylus pen may further include: a housing in which the inductor unit, the first elastic member, the magnetic body, and the rest portion of the core except for one end thereof are disposed; a first fixing member fixed in the housing; a second fixing member spaced a predetermined distance from the first fixing member in the housing; and a moving member that moves between the first fixing member and the second fixing member based on the movement of the core, in which the first elastic member is fixed in the second fixing member and compressed by the moving member that moves toward the second fixing member.

In an embodiment, the first fixing member may include: a first cavity in which the magnetic body is disposed; a second cavity in which a portion of the inductor unit is disposed; and a partition wall disposed between the first cavity and the second cavity and having a through-hole through which the core passes, in which the through-hole of the partition wall has a diameter greater than that of a through-hole of the magnetic body.

In an embodiment, the core may have a stepped portion disposed between the one end and the other end thereof, the one end of the core may have a thickness greater than that of the other end of the core based on the stepped portion, and each of a through-hole of the inductor unit and a through-hole of the first fixing member may have a diameter greater than that of the through-hole of the magnetic body.

In an embodiment, a distance between the magnetic body and the inductor unit may increase as the stepped portion pushes one surface of the magnetic body by an external force applied to the one end of the core.

In an embodiment, the stylus pen may further include an inner case disposed in the housing to surround the inductor unit, the first fixing member, the moving member, and the second fixing member, in which each of the first fixing member and the second fixing member includes at least one first protrusion that protrudes from an outer surface thereof, and the inner case includes a first opening in which the first protrusions of the first fixing member and the second fixing member are disposed.

In an embodiment, the first opening may include: a base groove extending in a longitudinal direction of the inner case; and a plurality of extension grooves connected to the base groove and extending in a direction perpendicular to the longitudinal direction of the base groove, in which the plurality of extension grooves are defined at positions corresponding to the first protrusions of the first fixing member and the second fixing member.

In an embodiment, the first fixing member may have at least one first groove defined in an outer surface thereof, the moving member may include at least one extension portion disposed in the first groove and has at least one first groove and at least one second groove defined in an outer surface thereof, and the second fixing member may include a first extension portion and a second extension portion disposed in the first groove and the second groove of the moving member, respectively, in which when the moving member moves, the extension portion of the moving member moves in the first groove of the first fixing member, and the first and second extension portions of the second fixing member are disposed in the first and second grooves of the moving member, respectively.

In an embodiment, the second elastic member may have a groove, the moving member may have a first groove, and the second fixing member may include a first extension portion disposed in the groove of the second elastic member and the first groove of the moving member.

In an embodiment, the stylus pen may further include: a capacitor unit including a base capacitor electrically connected to the inductor unit and a jumping capacitor that is electrically short-circuited or opened with the base capacitor; a substrate on which the capacitor unit is mounted; a ring terminal disposed on a surface of the moving member between the moving member and the first fixing member to move based on the movement of the moving member; and a connection terminal disposed on a side surface of each of the moving member and the second fixing member and having one end in contact with the ring terminal and the other end connected to a connection pad of the substrate, in which when the moving member moves and the ring terminal is separated from the one end of the connection terminal, the base capacitor and the jumping capacitor are electrically opened from each other.

In an embodiment, a groove in which the connection terminal is disposed may be defined in the side surface of each of the moving member and the second fixing member.

In an embodiment, a distance between the magnetic body and the inductor unit may be varied by the movement of the core, an inductance value of the inductor unit may be varied based on a variation of the distance, and a resonance frequency of a signal emitted to the outside may be varied based on a variation of the inductance value.

In an embodiment, the stylus pen may further include: a cover part disposed between the other end of the core and the moving member; and an elastic member disposed between the cover part and the magnetic body.

ADVANTAGEOUS EFFECTS

The stylus pen according to the embodiment of the present invention may clearly distinguish the hover motion, the contact motion, and the pen pressure motion.
Also, the stylus pen may decrease the number of inner components to reduce the manufacturing costs.
Also, the stylus pen may have the relatively small performance variation caused by the assembly deviation of the inner components.
Also, the stylus pen may have the simple internal structure.
Also, the stylus pen may distinguish the contact motion and the pen pressure motion by using the variation in spaced distance between the magnetic body and the inductor unit caused by the movement of the core.

BRIEF DESCRIPTION OF THE DRAWINGS

FIG. 1 is a perspective view illustrating a stylus pen 100 according to an embodiment of the present disclosure.

FIG. 2 is a cross-sectional view illustrating the stylus pen 100 in FIG. 1.

FIG. 3A is a perspective view for explaining a structure of an inner case 110 and a guide part 115 in FIG. 2, and FIG. 3B is a perspective view illustrating only the inner case 110.

FIG. 4 is a erspective view illustrating a state in which the inner case 110 in FIG. 3A is removed.

FIGS. 5A and 5B are perspective views illustrating a first fixing member 130 in FIGS. 2 and 4 from various angles.

FIGS. 6A and 6B are perspective views illustrating a moving member 170 in FIGS. 2 and 4 from various angles.

FIGS. 7A and 7B are perspective views illustrating a second fixing member 190 in FIGS. 2 and 4 from various angles.

FIG. 8 is a perspective view illustrating some components in FIGS. 2 and 4 from one side.

FIGS. 9A and 9B are perspective views illustrating only some components in FIGS. 2 and 4.

FIGS. 10A to 10C are views for explaining a motion of the stylus pen 100 in FIGS. 1 to 9.

FIG. 11A is a view illustrating a variation in LC value of a resonance circuit unit according to motions in FIGS. 10A to 10C.

FIG. 11B is a graph showing frequency characteristics in each of the motion states of FIGS. 10A to 10C.

FIGS. 12A to 12C are views for explaining a limitation caused by an assembly deviation of a core 102 when the stylus pen 100 in FIGS. 1 to 10 is assembled.

FIG. 13 is a graph showing a variation in resonance frequency according to pressure applied to the core 102 in each of FIGS. 12A to 12C.

FIGS. 14A to 14C are views for explaining a limitation caused by an assembly deviation of connection terminals 165a and 165b occurring when the stylus pen 100 in FIGS. 1 to 10 is assembled.

FIG. 15 is a perspective view illustrating a stylus pen 100' according to another embodiment of the present disclosure.

FIG. 16 is a cross-sectional view illustrating portion A' of the stylus pen 100' in FIG. 15.

FIGS. 17A and 17B are views for explaining a first elastic member 180' in FIG. 16.

FIGS. 18A to 18C are views for explaining a motion of the stylus pen 100' in FIGS. 15 to 17.

FIGS. 19A and 19B are views illustrating an example of an assembly deviation occurring in the core 102.

FIG. 20 is a graph showing a variation in resonance frequency according to pressure applied to the core 102 in each of FIGS. 19A and 19B.

**MODE FOR CARRYING OUT THE INVENTION**

The present invention will now be described more fully with reference to the accompanying drawings, in which exemplary embodiments of the invention are shown. These embodiments are provided so that this disclosure will be thorough and complete, and will fully convey the concept of the invention to those skilled in the art. The invention may, however, be embodied in many different forms and should not be construed as being limited to the embodiments set forth herein. Therefore, it will be understood that the embodiments disclosed in this specification includes some variations without limitations to the shapes as illustrated in the figures. Also, the position or the arrangement of each component in the embodiment may be varied without departing form the spirit or scope of the invention. The preferred embodiments should be considered in descriptive sense only and not for purposes of limitation. Therefore, the scope of the invention is defined not by the detailed description of the invention but by the appended claims, and all differences within the scope will be construed as being included in the present invention. In the drawings, like reference numerals refer to like elements throughout.

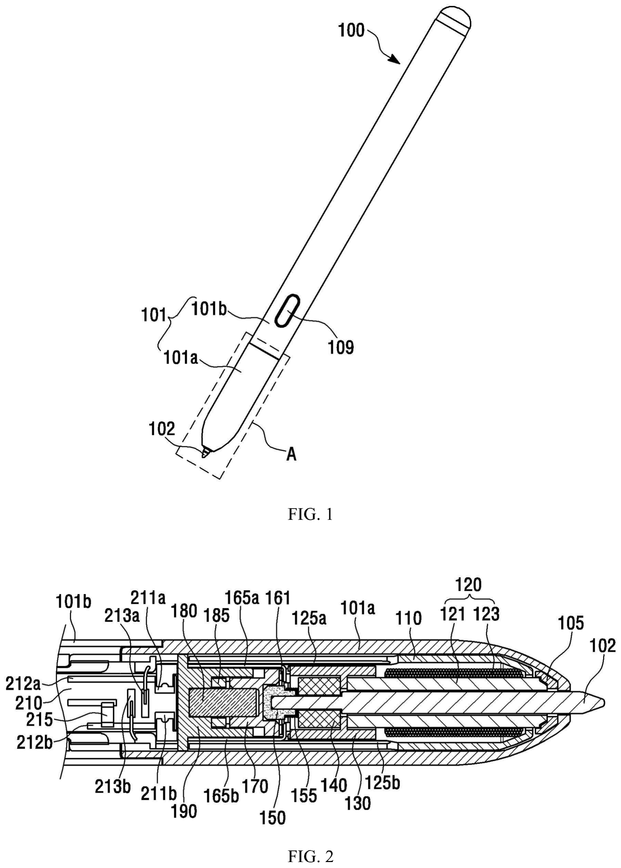

FIG. 1 is a perspective view illustrating a stylus pen 100 according to an embodiment of the present disclosure.

Referring to FIG. 1, a stylus pen according to an embodiment of the present invention includes a housing 101 and a core 102.

The housing 101 defines an appearance of the stylus pen 100. The housing 10 has a shape of a pen. The housing 101 may be formed such that two or more parts are coupled to each other or integrated into one piece.

The housing 101 may be made of a non-conductive synthetic resin material.

The housing 101 may include a first housing 101a and a second housing 101b. The first housing 101a and the second housing 101b may be coupled to each other to form the appearance of the stylus pen 100. Various components are embedded in the first housing 101a and the second housing 101b.

A button part 109 may be disposed on the housing 101. The button part 109 may be in the second housing 101b. The button part 109 is designed to perform a specific motion of the stylus pen 100. For example, the button part 109 may be a mechanical or touch-type button used for a cancel operation.

The core 102 includes one end that is disposed outside the housing 101, and the rest portion except the one end is disposed in the housing 101. One portion of the one end of the core 102 may move into the housing 101 by external force applied from the outside. As the external force increases, a volume of the one portion of the one end of the core 102, which moves into the housing 101, may increase. When the applied external force decreases, the one portion of the one end of the core 102 moves out of the housing 101 again. When the external force is not applied, the one portion of the one end of the core 102 is returned to an original state.

Hereinafter, various components disposed in the housing 101 will be described with reference to FIGS. 2 to 8.

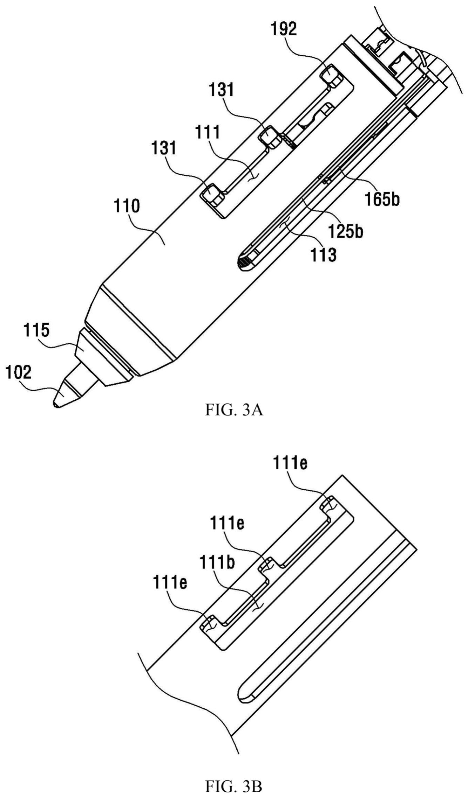

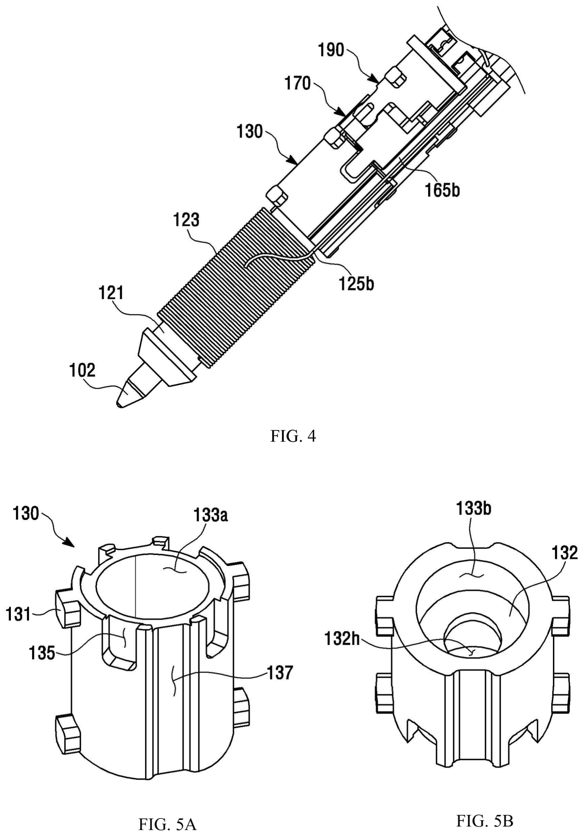

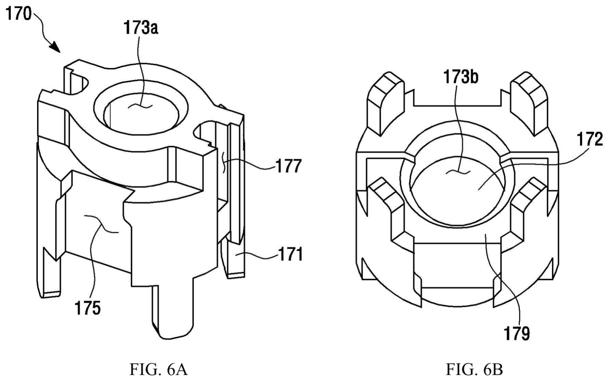

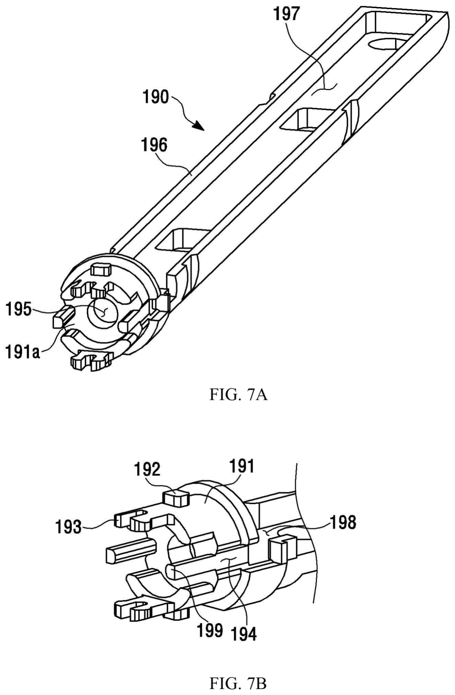

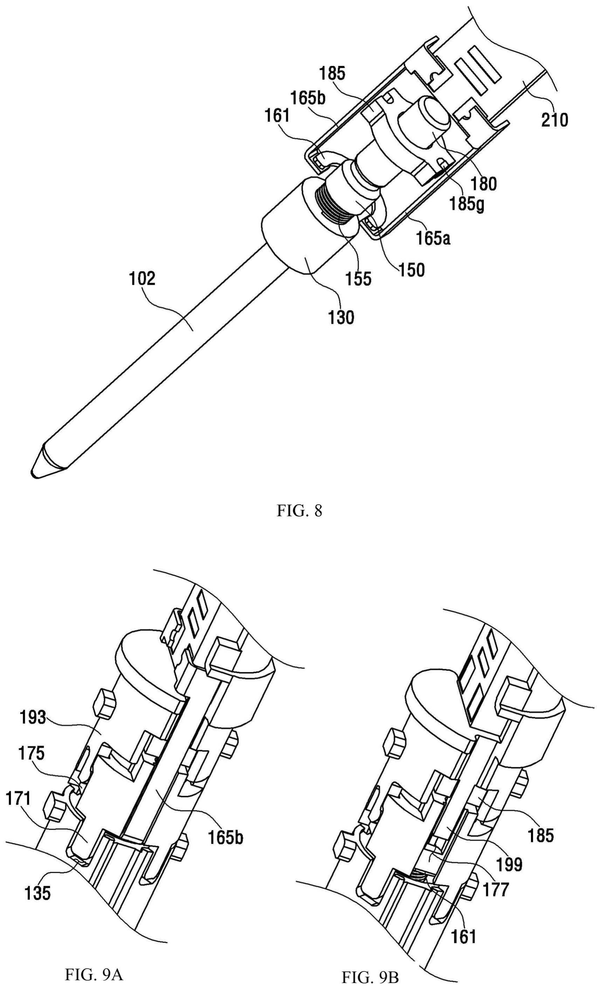

FIG. 2 is a cross-sectional view illustrating portion A of the stylus pen 100 in FIG. 1 according to an embodiment of the present invention, FIG. 3A is a perspective view for explaining structures of an inner case 110 and the guide part 115 in FIG. 2, FIG. 3B is a perspective view illustrating only the inner case 110. FIG. 4 is a perspective view illustrating a case in which the inner case 110 in FIG. 3A is removed, FIGS. 5A and 5B are perspective views illustrating a first fixing member 130 in FIGS. 2 and 4 from various angles, FIGS. 6A and 6B are perspective views illustrating a moving member 170 in FIG. 2 and 4 from various angles, FIGS. 7A and 7B are perspective views illustrating a second fixing member 190 in FIGS. 2 and 4 from various angles, FIG. 8 is a perspective view illustrating some components in FIGS. 2 and 4 from one side, and FIGS. 9A and 9B are perspective views illustrating only some components in FIGS. 2 and 4.

Referring to FIG. 2, the stylus pen 100 includes at least two of an inner case 110, a guide part 115, an inductor unit 120, a capacitor unit (not shown), a first fixing member 130, a magnetic body 140, a cover member 150, a ring terminal 161, connection terminals 165a and 165b, a moving member 170, a first elastic member 180, a second elastic member 185, an elastic body 155, a second fixing member 190, and a substrate 210.

The inner case 110 is made of a non-conductive material and is disposed in the housing 101. Specifically, the inner case 110 may be disposed in a first housing 101a of the housing 101. The inner case 110 may have a shape surrounding the inductor unit 120, the first fixing member 130, the ferrite chip 140, the cover member 150, the ring terminal 161, the connection terminals 165a and 165b, the moving member 170, the first elastic member 180, the second elastic member 185, the elastic body 155, and the second fixing member 190. The inner case 110 serves to protect various inner components from physical and/or electrical impacts.

Referring to FIG. 2 and FIGS. 3A and 3B, the inner case 110 may have a first opening 111 in which a first protrusion 131 of the first fixing member 130 and a first protrusion 192 of the second fixing member 190 are disposed. The first opening 111 may have a base groove 111b extending in a longitudinal direction of the stylus pen 100 and a plurality of extension grooves 111e connected to the base groove 111b and extending in a direction perpendicular to the longitudinal direction of the base groove 111b. The plurality of extension grooves 111e may be disposed at positions corresponding to a plurality of first protrusions 131 and 192. For example, the first opening 111 may have an "E"-shape.

The plurality of first protrusions 131 and 192 may move from the plurality of extension grooves 111e to the base groove 111b or from the base groove 111b to the plurality of extension grooves 111e by rotating the inner case 110 using the core 102 as a rotation axis in a counterclockwise or clockwise direction. Specifically, positions of the first fixing member 130 and the second fixing member 190 may be fixed in the inner case 110 by moving the plurality of first protrusions 131 and 192 from the base groove 111b to the plurality of extension grooves 111e. On the other hand, the moving member 170 may move based on a linear reciprocating movement of the core 102 caused by external force between the first fixing member 130 and the second fixing member 190 because the moving member 170 is not directly coupled to the inner case 110.

The inner case 110 may have a second opening 113 in which extension coils 125a and 125b are disposed and from which the connection terminals 165a and 165b

9     **EP 4 647 879 A2**     10

are exposed. The second opening 113 may provide a space in which the extension coils 125a and 125b are disposed and protect the extension coils 125a and 125b from external impacts. Also, a mounting position of the connection terminals 165a and 165b may be easily checked through the second opening 113.

The guide part 115 may be disposed between the inductor unit 120 and the housing 101 and between the core 102 and the inner case 110. The guide part 115 has a through-hole through which the core 102 passes. The guide part 115 may guide a position of the core 102, stably fix the inductor unit 120, and block the inductor unit 120 from external electrical or magnetic effects. Although the guide part 115 may be provided separately from the inner case 110, the embodiment of the present invention is not limited thereto. For example, the guide part 115 may be integrated with the inner case 110.

Referring to FIGS. 2 and 4, the guide part 115, the inductor unit 120, the first fixing member 130, the moving member 170, and the second fixing member 190 may be arranged sequentially along a longitudinal direction (hereinafter, referred to as a "longitudinal direction") of the stylus pen 100 from one end of the core 102. That is, along the longitudinal direction, the inductor unit 120 may be disposed on the buffer member 115, the first fixing member 130 may be disposed on the inductor unit 120, the moving member 170 may be disposed on the first fixing member 130, and the second fixing member 190 may be disposed on the moving member 170.

The inductor unit 120 includes a ferrite core 121 and a coil 123 wound around the ferrite core 121. The ferrite core 121 has a through-hole through which the core 102 passes. The core 102 may perform a linear reciprocating movement along the longitudinal direction through the through-hole. The coil 123 may be wound around the ferrite core 121 with at least one layer. The extension coils 125a and 125b may be connected to both ends of the coil 123, respectively. The extension coils 125a and 125b may each extend along the longitudinal direction and be connected to coil electrodes 213a and 213b disposed on the substrate 210, respectively.

The inductor unit 120 is fixedly installed in the housing 101. The inductor unit 120 may be fixed between the first fixing member 130 and the guide part 115 in the longitudinal direction. The inductor unit 120 may be fixed by the inner case 110 in a direction (hereinafter, referred to as a "vertical direction") perpendicular to the longitudinal direction.

The inductor unit 120 may be fixed at one side of the first fixing member 130. Here, a portion of the inductor unit 120 may be disposed in a second cavity 133b of the first fixing member 130.

The inductor unit 120 may be electrically connected to a capacitor unit (not shown) mounted to the substrate 210 to constitute a resonance circuit unit. A resonance frequency may be set by a value of inductance L of the inductor unit 120 and a value of capacitance C of the capacitor unit (not shown). The resonance frequency may be varied because the value of inductance L of the inductor unit 120 is varied according to a movement of the magnetic body 140.

The capacitor unit (not shown) is disposed on the substrate 210. The capacitor unit (not shown) has a preset value of the capacitance C. The capacitor unit (not shown) may include two or more capacitors. The circuit may be constituted such that at least one of the two or more capacitors is always electrically connected to the inductor unit 120 as a basic capacitor.

The capacitor unit (not shown) includes a jumping capacitor 215. The circuit may be constituted such that the jumping capacitor 215 is mounted on the substrate 210 and electrically connected to the connection terminals 165a and 165b. For example, the jumping capacitor 215 may be electrically connected to connection pads 211a and 211b disposed on the substrate 210 through conductive patterns 212a and 212b. The jumping capacitor 215 may be electrically connected to or disconnected from the basic capacitor according to the movement of the core 102. Since the ring terminal 161 is in contact with the contact terminals 165a and 165b when external force is not applied to the core 102, the jumping capacitor 215 is connected to the base capacitor. On the other hand, when the moving member 170 that operates together with the core moves toward the first elastic member 180 as external force is applied to the core 102, the ring terminal 161 is detached from the connection terminals 165a and 165b. Here, the jumping capacitor 215 may be electrically disconnected from the base capacitor.

Referring to FIGS. 2 and 4 and FIGS. 5A and 5B, the first fixing member 130 is disposed in the inner case 110. The first fixing member 130 has an overall cylindrical shape. The first fixing member 130 has a first cavity 133a and a second cavity 133b. The magnetic body 140 in FIG. 2 is disposed in the first cavity 133a, and one end of the ferrite core 121 of the inductor unit 120 in FIG. 2 is disposed in the second cavity 133b. A partition wall 132 is disposed between the first cavity 133a and the second cavity 133b, and the partition wall 132 has a through-hole 132h through which the core 102 passes.

The inductor unit 120 is disposed at one side of the first fixing member 130, and the second fixing member 190 is spaced at a predetermined distance from the other side of the first fixing member 130.

The plurality of first protrusions 131 that are described above may be disposed on an outer surface of the first fixing member 130.

A plurality of first grooves 135 in which a plurality of extension portions 171 are disposed, respectively, may be formed in the outer surface of the first fixing member 130. Also, a second groove 137 formed along the longitudinal direction to maintain a constant distance with the extension coils 125a and 125b illustrated in FIG. 4 may be formed in the outer surface of the first fixing member 130.

Referring to FIGS. 2 and 4 and FIGS. 6A and 6B,

6

the moving member 170 is disposed between the first fixing member 130 and the second fixing member 190. The moving member 170 may perform a linear reciprocating movement between the first fixing member 130 and the second fixing member 190 in conjunction with a longitudinal movement of the core 102.

The moving member 170 is disposed in the inner case 110. The moving member 170 has an overall cylindrical shape. The moving member 170 includes a first cavity 173a and a second cavity 173b. A portion of the first elastic member 180 in FIG. 2 is disposed in the first cavity 173a, and a portion of the cover member 150 in FIG. 2 is disposed in the second cavity 173b. A partition wall 172 is disposed between the first cavity 173a and the second cavity 173b, and the partition wall 172 is disposed between the cover member 150 and the first elastic member 180.

The plurality of extension portions 171 disposed in the plurality of first grooves 135 are disposed on the outer surface of the moving member 170. The plurality of extension portions 171 may each have a shape extending along the longitudinal direction and move along the first grooves 135 of the first fixing member 130.

A plurality of second grooves 175 in which the second extension portions 193 of the second fixing member 190 in FIGS. 7A and 7B are disposed, respectively, may be formed on the outer surface of the moving member 170. As the moving member 170 performs the linear reciprocating movement along the longitudinal direction, the second grooves 175 also move accordingly. Thus, a position of the second extension portions 193 of the second fixing member 190 disposed in the second grooves 175 may be changed.

The second groove 175 of the moving member 170 may have a shape corresponding to the second extension portion 193 of the second fixing member 190. The second groove 175 may have a shape that prevents the second extension portion 193 of the second fixing member 190 from completely separated from the second groove 175 when the moving member 170 moves apart from the second fixing member 190. To this end, the second groove 175 may have a shape having a width that gradually decreases in a direction toward the second fixing member 190, and the second extension portion 193 of the second fixing member 190 may have a shape that protrudes in a width direction of the second groove 175.

A first groove 177 may be formed in the outer surface of the moving member 170. The first groove 177 may be elongated in the longitudinal direction, and the connection terminals 165a and 165b may be disposed in the first groove 177 as illustrated in FIG. 9B. The first groove 177 may fix and guide a position of the connection terminals 165a and 165b. Also, the first extension portion 192 of the second fixing member 190 may be disposed in the first groove 177 together with the connection terminals 165a and 165b.

Since the moving member 175 is disposed between the first fixing member 130 and the second fixing member 190, an extension portion 171 of the moving member 170 is disposed in the first groove 135 of the first fixing member 130, and first and second extension portions 193 and 199 of the second fixing member 190 are disposed in the first and second grooves 175 and 177 of the moving member 170, the moving member 175 may not be separated to the outside even during frequent movements.

The moving member 170 may include one surface 179 in which the first cavity 173a is defined, and the ring terminal 161 in FIGS. 2 and 8 may be disposed on the one surface 179. The one surface 179 may have a shape corresponding to that of the ring terminal 161. The ring terminal 161 disposed on the one surface 179 may be guided by an inner surfaces of at least one extension portion 171 disposed therearound.

Referring to FIGS. 2, 4, and 7, the second fixing member 190 is fixed in the housing 101. At least a portion of the second fixing member 190 is fixed in the inner case 110.

The second fixing member 190 includes a cylindrical base portion 191. One surface 191a of the base portion 191 has a cavity 195 in which a portion of the first elastic member 180 in FIG. 2 is disposed. The second elastic member 185 in FIG. 2 is disposed on the one surface 191a of the base portion 191.

The second fixing member 190 includes a first extension portion 199 and a second extension portion 193, each of which extends from the one surface of the base portion 191 towards the moving member 170. A plurality of first extension portions 199 and a plurality of second extension portions 193 may be disposed on the one surface 191a of the base portion 191. Specifically, two first extension portions 199 may be disposed to face each other, and two second extension portions 193 may be disposed to face each other. The plurality of first and second extension portions 191 and 199 guide an outer surface of the second elastic member 185 in FIG. 2 from all directions. Thus, a position of the second elastic member 185 may be fixed by the plurality of first and second extension portions 191 and 199.

The first extension portion 199 may have an inner surface that guides an outer surface of the second elastic member 185 and an outer surface that supports a portion of the connection terminals 165a and 165b in FIGS. 2 and 4.

The second extension portion 193 has a predetermined shape so as not to be separated from the second groove 175 after being coupled to the second groove 175 of the moving member 170. For example, the second extension portion 193 may have a shape in which at least a portion protrudes to prevent separation from the second groove 175.

The second fixing member 190 may have a groove 194 defined in an outer surface of the base portion 191. A bottom surface of the groove 194 may be connected to the outer surface of the first extension portion 199 without a stepped portion. A portion of the connection terminals 165a and 165b in FIGS. 2 and 4 may be disposed in the groove 194.

The second fixing member 190 may include a seat portion 196 that extends along the longitudinal direction from the other surface (not shown) of the base portion 191. The seat portion 196 may have a cavity 197 in which the substrate 210 in FIGS. 2 and 4 is disposed.

The second fixing member 190 may have an opening 198 for connecting the connection terminals 165a and 165b in FIGS. 2 and 4 to the substrate 210 disposed in the cavity 197. The other ends of the connection terminals 165a and 165b may be disposed in the opening 198 and connected to the connection pads 211a and 211b of the substrate 210.

Referring to FIGS. 2, 4, and 8 and FIGS. 9A and 9B, the core 102 may extend a predetermined length in the longitudinal direction, and one end thereof may have a sharp shape. Here, the one end is exposed to the outside of the housing 101.

The core 102 includes a stepped portion 102T disposed on one portion of an intermediate portion between one end and the other end. One end and the other end of the intermediate portion may have different thicknesses based on the stepped portion 102T. Based on the stepped portion 102T, the one end of the intermediate portion may have a first thickness D1 greater than a second thickness D2 of the other end of the intermediate portion. The above-described stepped portion 102T allows the magnetic body 140 to move together when the core 140 moves along the longitudinal direction by external force. That is, when the core 102 moves, the stepped portion 102T may push one surface of the magnetic body 140 to move the magnetic body 140 in the longitudinal direction. As the magnetic body 140 moves along the longitudinal direction, a spaced distance between the inductor unit 120 and the magnetic body 140 is varied. The variation in distance allows a value of the inductance L of the inductor unit 120 to vary, and the variation in value of the inductance allows the resonance frequency of the stylus pen 100 to vary. The stylus pen sensing device that interacts with the stylus pen 100 may sense a variation in the resonance frequency to detect a pen pressure (pressure) applied to the core 102.

The magnetic body 140 is disposed in the first cavity 133a of the first fixing member 130 in FIGS. 5A and 5B and has a cylindrical shape. Also, the magnetic body 140 has a through-hole through which a portion of the core 102 passes. The through-hole may have a diameter equal to or greater than the second thickness D2 and less than the first thickness D1.

The magnetic body 140 may be a ferrite chip.

The magnetic body 140 may perform a linear reciprocating movement along the longitudinal direction in conjunction with the core 102. As the magnetic body 140 moves based on a movement of the core 102, the value of the inductance L of the inductor unit 120 may be varied.

A cover part 161 is disposed at the other end of the core 102. The cover part 161 may have a shape covering the other end of the core 102. For example, the cover part 161 may have a cylindrical shape having different thicknesses at upper and lower portions.

The elastic member 155 may be disposed between the cover portion 161 and the magnetic body 140. The elastic member 155 may be a spring. The elastic member 155 may have one end that is inserted into a portion of the cover part 161 and the other end and the other end that is in contact with the magnetic body 140.

The elastic member 155 may compensate a deviation of the magnetic body 140. For example, when a length (or height) of the magnetic body 140 is less by 0.1mm than a specification, the elastic member 155 allows the magnetic body 140 to be in close contact with the partition wall 132 of the first fixing member 130.

The ring terminal 161 is a hollow circle and electrically connects two connection terminals 165a and 165b. Here, the embodiment of the present invention is not limited to the shape of the ring terminal 161. For example, the ring terminal 161 may have a polygonal shape.

The ring terminal 161 is disposed on one surface of the moving member 170 and operates in conjunction with the moving member 170. That is, the ring terminal 161 moves together with the linear reciprocating movement of the moving member 170 in the longitudinal direction.

Each of the connection terminals 165a and 165b includes one end that contacts or separates from the ring terminal 161 and the other end connected to the substrate 210. The one end may contact or separate from the ring terminal 161 by a movement of the ring terminal 161 that operates in conjunction with the moving member 170. The other end is directly connected to the connection pads 211a and 211b of the substrate 210 in FIG. 2 through soldering and the like.

The connection terminals 165a and 165b include a base portion disposed between the one end and the other end. This base portion may have a shape extending in the longitudinal direction. The base portion may be disposed in the first groove 177 of the moving member 170 in FIGS. 6A and 6B and in the groove 194 of the second fixing member 190 in FIGS. 7A and 7B. The base portion may be guided by the first extension portion 199 of the second fixing member 190.

The first elastic member 180 is disposed in the second fixing member 190. The first elastic member 180 may have a cylindrical shape that is elongated in the longitudinal direction. The first elastic member 180 may be made of a rubber material.

The first elastic member 180 may have one end disposed in the cavity 195 of the second fixing member 190 in FIGS. 7A and 7B and the other end disposed in the first cavity 173a of the moving member 170 in FIGS. 6A and 6B.

The second elastic member 185 is disposed in the second fixing member 190. The second elastic member 185 may have a flat cylindrical shape. The second elastic member 185 may be made of a rubber material. The second elastic member 185 may be made of a rubber material that is harder relative to that of the first elastic member 180. Thus, the second elastic member 185 may be made of a hard rubber material, and the first elastic member 180 may be made of a soft rubber material.

On the other hand, the second elastic member 185 may be a spring. The second elastic member 185 may be a spring configured to respond to relatively heavier force than the first elastic member 180.

The second elastic member 185 has a thickness in the longitudinal direction, which is less than that of the first elastic member 180, and a diameter in the vertical direction, which is greater than that of the first elastic member 180.

The second elastic member 185 is disposed to surround an intermediate portion of the first elastic member 180. Thus, the second elastic member 185 has a through-hole through which the first elastic member 180 passes.

As illustrated in FIG. 9B, the second elastic member 185 may have a groove 185g that is inserted into a portion of the first extension portion 199 of the second fixing member 190. Through this, the second elastic member 185 may be stably fixed to the second fixing member 190.

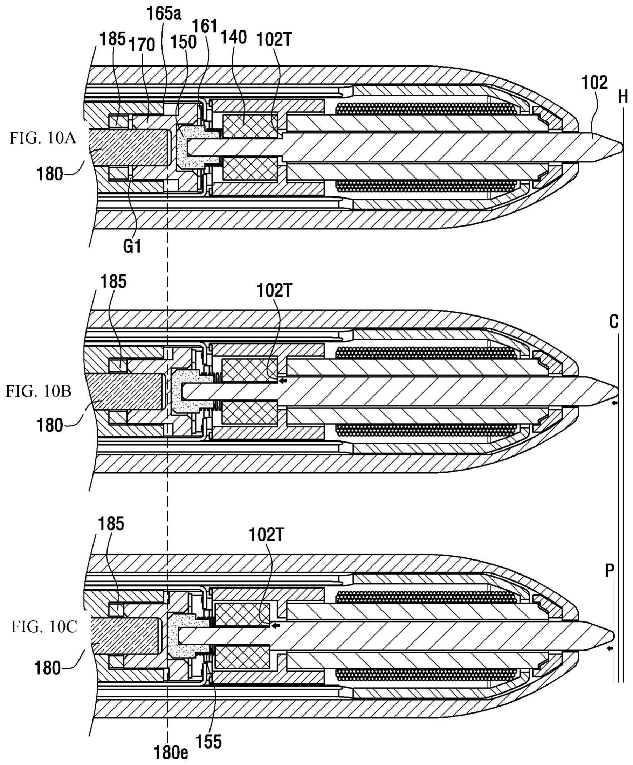

Hereinafter, a motion of the stylus pen 100 according to an embodiment in FIGS. 1 to 9 will be described with reference to FIGS. 10A to 10C.

FIGS. 10A to 10C are views for explaining the motion of the stylus pen 100 in FIGS. 1 to 9. Specifically, FIG. 10A is a view illustrating a hover state H of the stylus pen 100, FIG. 10B is a view illustrating a contact state C of the stylus pen 100, and FIG. 10C is a view illustrating a pen pressure state P of the stylus pen 100.

Referring to FIG. 10A, since external force is not applied to the core 102 in the hover state H, the inner components are not changed. In particular, the ring terminal 161 and the connection terminals 165a and 165b maintain a contact state therebetween.

Referring to FIG. 10B, in the contact state C, a predetermined pressure is applied to one end of the core 102. The applied pressure causes the core 102 to move in an inward direction of the housing 101. As the core 102 moves, the cover part 150 pushes the moving member 170 towards the first elastic member 180, and the ring terminal 161 is separate from the connection terminals 165a and 165b. Accordingly, the jumping capacitor 215 in FIG. 2 is electrically disconnected from the base capacitor, and overall capacitance of the capacitor unit (not shown) decreases. Here, since the magnetic body 140 does not move, the value of the inductance of the inductor unit 120 remains unchanged. Since the overall capacitance value of the capacitor unit (not shown) decreases, the resonance frequency is varied.

Referring to FIG. 10C, in the pen pressure state P, greater pressure is applied to one end of the core 102 than that in the contact state C. The greater pressure causes the core 102 to move further in an inward direction of the housing 101. Accordingly, the magnetic body 140 is pushed by the stepped portion 102T of the core 102. As the magnetic body 140 is pushed, the elastic body 155 disposed between the cover part 150 and the magnetic body 140 is pressed, and as the moving member 170 moves, the first elastic member 180 and the second elastic member 185 are pressed. Here, since the magnetic body 140 moves apart from the inductor unit 120, the value of the inductance L of the inductor unit 120 gradually decreases. Here, the capacitance of the capacitor unit (not shown) remains the same as that in the contact state C. Since the inductance value of the inductor unit 120 decreases, the resonance frequency is varied.

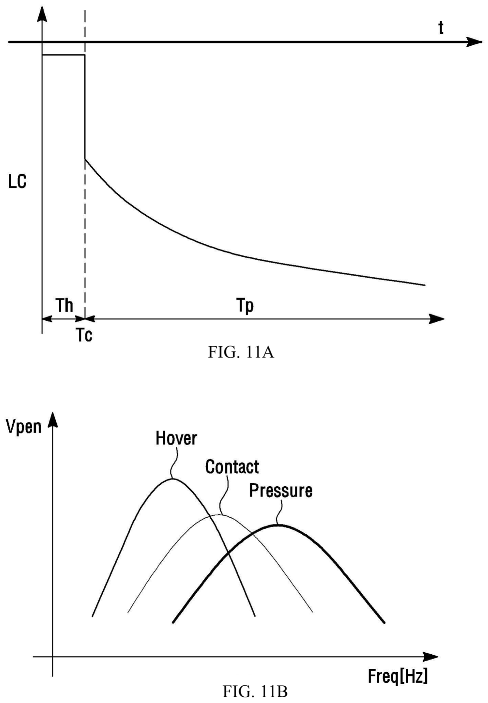

FIG. 11A is a view illustrating a variation in LC value of the resonance circuit unit according to the operations in FIGS. 10A to 10C. Here, a Th period represents the hover state of FIG. 10A, a Tc point represents the contact state of FIG. 10B, and a Tp period represents the pressure state of FIG. 10C. FIG. 11B is a graph showing frequency characteristics in each of the operating states of FIG. 10A to 10C.

Referring to FIG. 11A, a LC value of the resonance circuit unit including the capacitor unit (not shown) and the inductor unit 120 maintains a constant value before Th the core 102 of the stylus pen 100 contacts a touch surface Th and significantly decreases directly after Tc the core 102 contacts the touch surface Tc. Also, in the period Tp in which pen pressure is applied to the stylus pen 100 after the stylus pen 100 contacts the touch surface, the LC value of the resonance circuit unit decreases further according to the pen pressure. That is, in this period Tp, as the pen pressure applied to the stylus pen 100 increases, the LC value of the resonance circuit unit may gradually decrease. Referring to FIG. 11A, the LC value of the resonance circuit unit shows hover state > contact state > pen pressure state. Also, immediately after the core 102 contacts the touch surface, an amount of variation in LC value is more significant in a state in which the pen pressure gradually increases.

When the value of the inductance of the inductor unit 120 and the value of the capacitance of the capacitor unit (not shown) are varied, the resonance frequency and the Q value of the resonance circuit unit may be also varied. The resonance frequency of the resonance circuit unit increases as the inductance of the resonance circuit unit decreases, and the Q value decreases as the inductance decreases. Thus, as illustrated in FIG. 11B, frequency characteristics of a resonance signal Vpen output from the resonance circuit unit may show that, as a movement distance of the core 102 increases, i.e., the pen pressure increases, the resonance frequency increases (hover state < contact state < pen pressure state), and the Q value decreases (hover state > contact state > pen pressure state).

When the resonance frequency of the resonance circuit unit is varied, a phase of the electromagnetic signal output from the stylus pen 100 is changed. The stylus pen sensing device that interacts with the stylus pen 100 may calculate the variation in the LC value of the resonance circuit unit, and based on this, whether the stylus pen 100 is in contact with the stylus pen sensing device and the pen pressure thereof may be detected.

As described above, the stylus pen 100 according to an embodiment in FIGS. 1 to 9 may change at least one or both of the inductance value and the capacitance value of the resonance circuit unit to detect the pen pressure in the stylus pen sensing device. Also, the stylus pen 100 may have an advantage of sensing precise pressure.

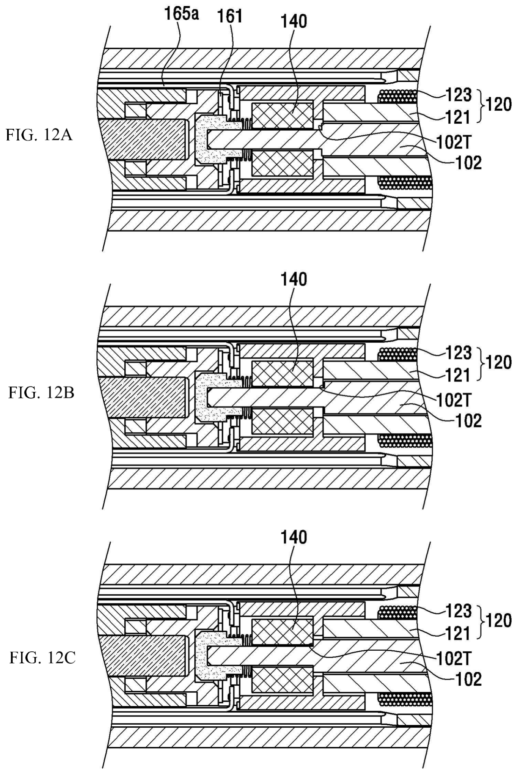

On the other hand, the stylus pen according to an embodiment in FIGS. 1 to 9 may have an assembly deviation during an assembly process. Since the assembly deviation may cause a predetermined limitation, the assembly deviation will be described in detail below with reference to FIGS. 12 to 14.

FIGS. 12A to 12C are views for explaining a limitation caused by an assembly deviation of a core 102 when the stylus pen 100 in FIGS. 1 to 10 is assembled.

Specifically, FIG. 12A shows a case in which the core 102 is mounted as designed in advance without the assembly deviation, and FIGS. 12B and 12C show a case in which the core 102 is not mounted in a designed position by an assembly deviation occurring during the assembly process.

In FIG. 12A, the stepped portion 102T of the core 102 is disposed in the through-hole 132h formed in the partition wall 132 of the first fixing member 130. A position of the stepped portion 102T is assembled correctly without any deviation. On the other hand, in FIGS. 12B and 12C, the stepped portion 102T is disposed at a different position instead of the through-hole 132h of the partition wall 132. Specifically, the stepped portion 102T is disposed in the second cavity 133b (refer to FIG. 5B) of the first fixing member 130, in which the inductor unit 120 is disposed, in FIG. 12B, and the stepped portion 102T is disposed in the first cavity 133a (refer to FIG. 5A) of the first fixing member 130, in which the magnetic body 140 is disposed, in FIG. 10C.

When the assembly deviation occurs as in FIG. 12B, pressure is continuously applied to the core 102 immediately after the contact state in FIG. 10B, the inductance value of the inductor unit 120 is not changed immediately because a distance between the inductor unit 120 and the magnetic body 140 is constant. On the other hand, in case of FIG. 12C, as the magnetic body 140 moves by the core 102 between the hover state of FIG. 10A and the contact state of FIG. 10B, the inductance value of the inductor unit 120 may be varied.

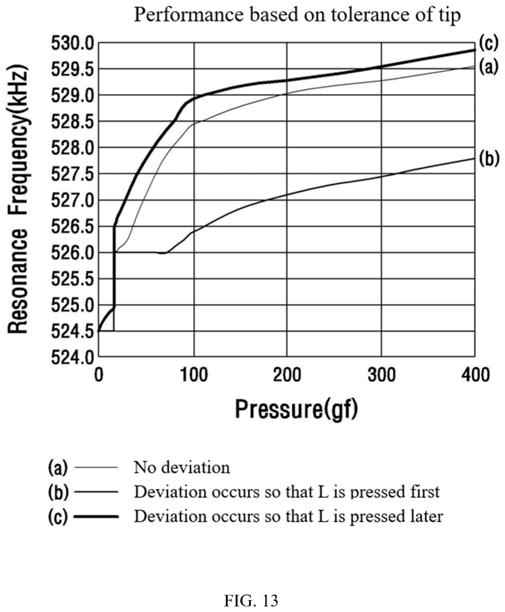

The variation in resonance frequency according to the pressure applied to the core 102 in each of FIGS. 12A to 12C will be described with reference to FIG. 13.

In a graph of FIG. 13, line ① corresponds to FIG. 12A without an assembly deviation, line ② corresponds to FIG. 12C with the assembly deviation, and line ③ corresponds to FIG. 12B with the assembly deviation.

Referring to FIG. 13, in case of line ③, the resonance frequency is not varied although the pressure applied to the core 102 increases immediately after the contact state. Thus, the stylus pen sensing device that interacts with the stylus pen 100 may not detect the pen pressure applied to the core 102. In case of line ②, since the resonance frequency is varied even in the hover state, the stylus pen sensing device may recognize the core 102 as being in the contact state instead of the hover state. As described above, due to the assembly deviation in FIGS. 12B and 12C, the stylus pen sensing device may not accurately detect the stylus pen 100.

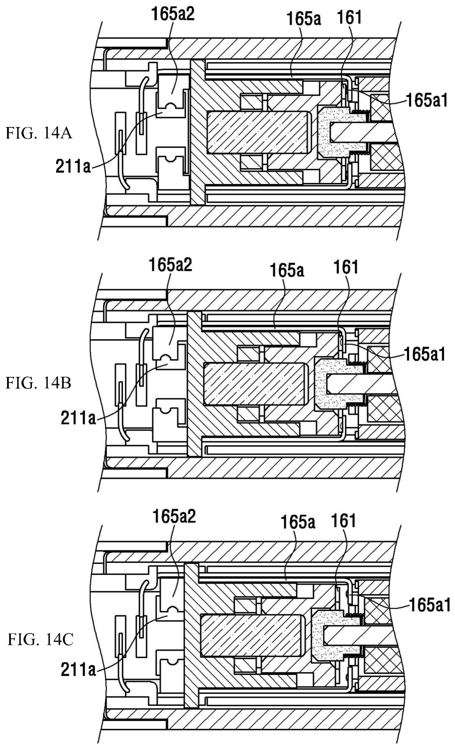

FIGS. 14A to 14C are views for explaining a limitation caused by an assembly deviation of connection terminals 165a and 165b occurring when the stylus pen 100 in FIGS. 1 to 10 is assembled; Specifically, FIG. 14A shows a case in which the connection terminals 165a and 165b are mounted as designed without any assembly deviation, and FIGS. 14B and 14C show cases in which the connection terminals 165a and 165b are not mounted at designed positions due to the assembly deviation.

In FIG. 14A, one end 165a1 of the connection terminal 165a is in contact with the ring terminal 161, and the other end 165a2 is in contact with the connection pad 211a of the substrate 210. A position of the connection terminal 165a is assembled correctly without any deviation. On the other hand, in FIGS. 14B and 14C, the connection terminal 165a is disposed at a different position instead of a designed position due to the assembly deviation. Specifically, in FIG. 14B, as the connection terminal 165a is offset by a predetermined distance towards the substrate 210, the one end 165a1 presses the ring terminal 161 with considerable force. In FIG. 14C, as the connection terminal 165a is offset by a predetermined distance towards the first fixing member 130, the one end 165a1 is spaced a predetermined distance from the ring terminal 161.

When the assembly deviation occurs as in FIG. 14B, since the connection terminal 165a and the ring terminal 161 are assembled in a state of being pressed by each other, there is a limitation in that pressure increases to recognize the contact state in FIG. 10B. On the other hand, in case of FIG. 14C, the ring terminal 161 and the connection terminal 165a are separated from the hover state of FIG. 10A, the stylus pen sensing device may not sense the contact state of FIG. 10B although pressure is applied to the core 102.

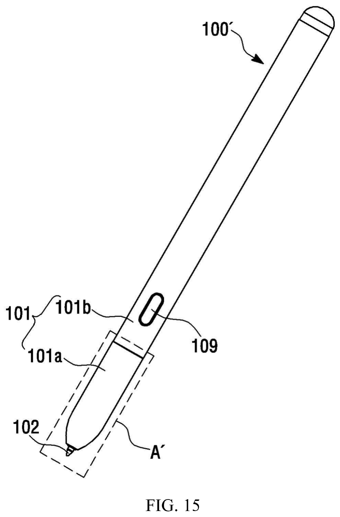

Hereinafter, a stylus pen according to another embodiment, which is not significantly affected in performance although the assembly deviation described with reference to FIGS. 12 to 14 occurs and reduced in manufacturing cost by reducing the number of inner components, will be described with reference to FIGS. 15 to 20.

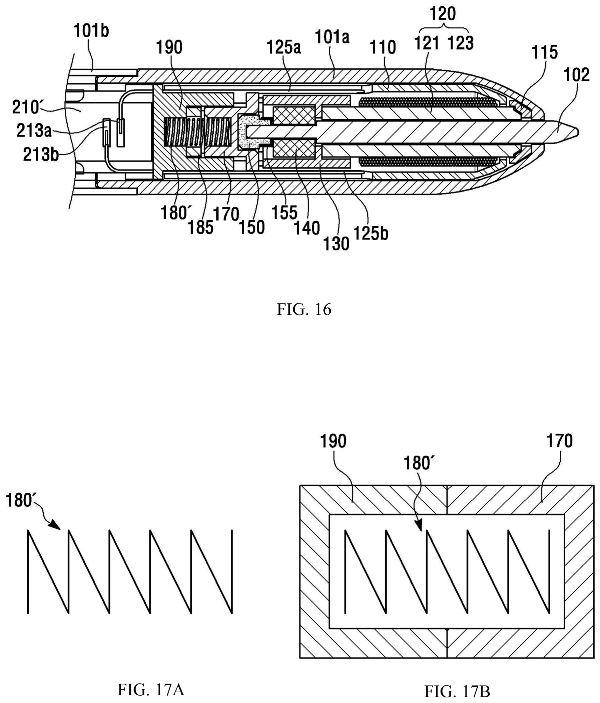

FIG. 15 is a perspective view illustrating a stylus pen 100' according to another embodiment of the present invention, and FIG. 16 is a cross-sectional view illustrating portion A' of the stylus pen 100' in FIG. 15.

When compared with the stylus pen 100 in FIGS. 1 to 10, the stylus pen 100' in FIGS. 15 and 16 is different in that: 1) a first elastic member 180' is made of a spring instead of a rubber material, and 2) the ring terminal 161, the connection terminals 165a and 165b, the jumping capacitor 215, and components for electrical connection therebetween of the stylus pen 100 in FIGS. 1 to 10 are omitted. Since the rest components except for the above-described components are the same as those of the stylus pen 100 in FIGS. 1 to 10, a detailed description thereof will be replaced with the above description, and only different components will be described in detail below.

Referring to FIGS. 15 and 16, the first elastic member 180' includes a spring. The first elastic member 180' may be pressed even under low pressure (e.g., about 10 gf) and disposed to be pressed quickly even when pressure slightly increases due to a low compression strength thereof.

FIGS. 17A and 17B are views for explaining the first elastic member 180' in FIG. 16. FIG. 17A is a view illustrating a state in which no force is applied to the first elastic member 180', and FIG. 17B is a view illustrating a state in which the first elastic member 180' is disposed between the moving member 170 and the second fixing member 190 in FIG. 16.

As illustrated in FIG. 17B, the first elastic member 180' is inserted between the moving member 170 and the second fixing member 190 in a partially pressed (or incompletely pressed) state. The first elastic member 180' is not pressed unless force (or repulsive force) greater than the pressed force applied by the moving member 170 and the second fixing member 190. Here, the force (or repulsive force) may be, e.g., about 10 gf. On the other hand, the second elastic member 190 is pressed when force greater than the applied pressed force is applied through the moving member 170.

Below is <Mathematical equation 1> that represents force F (or repulsive force) of the partially pressed first elastic member 180'.

[Mathematical equation 1]

$$ F = -kx = -\frac{Gd^4}{8NaD^3}x $$

In the above <Mathematical equation 1>, G is a transverse elastic modulus of the spring, Na is an effective number of winding of the spring, D is a diameter of the spring, d is a diameter of a wire, and x is a pressed (-direction) length of the spring.

On the other hand, the first elastic member 180' in a non-pressed state may be disposed between the moving member 170 and the second fixing member 190. Thus, the stylus pen 100' according to another embodiment of the present invention is not limited to the state in which a portion of the first elastic member 180' in a pressed state is disposed between the moving member 170 and the second fixing member 190.

The first elastic member 180' may be configured to respond to a relatively greater weight than the elastic body 155.

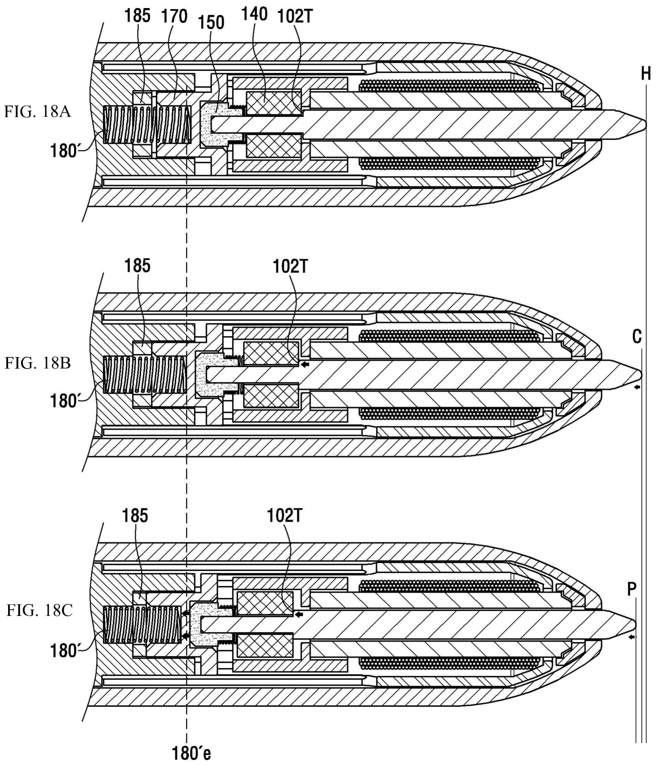

Hereinafter, a motion of the stylus pen 100' according to another embodiment in FIGS. 15 to 17 will be described with reference to FIGS. 18A to 18C.

FIGS. 18A to 18C are views for explaining a motion of the stylus pen 100' in FIGS. 15 to 17. Specifically, FIG. 18A is a view illustrating a hover state H of the stylus pen 100', FIG. 18B is a view illustrating a contact state C of the stylus pen 100', and FIG. 18C is a view illustrating a pen pressure state P of the stylus pen 100'.

Referring to FIG. 18A, since external force is not applied to the core 102 in the hover state H, the inner components are not changed.

Referring to FIG. 18B, in the contact state C, a predetermined pressure is applied to one end of the core 102. The applied pressure causes the core 102 to move in an inward direction of the housing 101. As the core 102 moves, the cover part 150 pushes the moving member 170 toward the first elastic member 180' upto the second elastic member 185. In this situation, the first elastic member 180' is pressed as much as the moving member 170 is pushed. Also, as the core 102 moves, the stepped portion 102T of the core 102 pushes the magnetic body 140 towards the first elastic member 180'. As the magnetic body 140 is pushed, a distance between the inductor unit 120 and the magnetic body 140 is changed, and this changed distance changes the inductance value of the inductor unit 120 and resultantly changes the resonance frequency.

Referring to FIG. 18C, in the pen pressure state P, greater pressure is applied to one end of the core 102 than that in the contact state C. The greater pressure causes the core 102 to move further in the inward direction of the housing 101, and resultantly the magnetic body 140 moves further away from the inductor unit 120. As the magnetic body 140 moves, the elastic body 155 disposed between the cover part 150 and the magnetic body 140 is pressed, and the movement of the moving member 170 causes the first elastic member 180' to be further pressed and the second elastic member 185 to be also pressed. Here, since the magnetic body 140 moves further away from the inductor unit 120, the inductance L value of the inductor unit 120 gradually decreases. Since the inductance value of the inductor unit 120 decreases, the resonance frequency is varied.

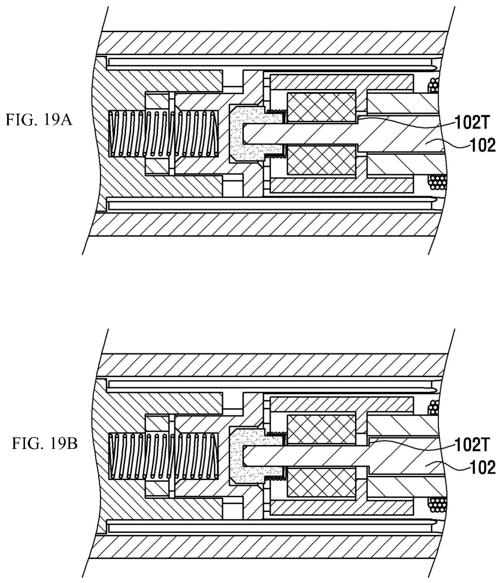

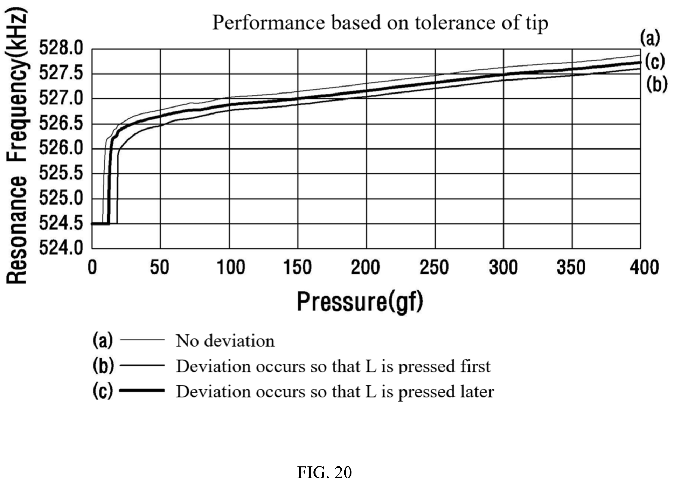

FIGS. 19A and 19B are views illustrating an example of the assembly deviation occurring in the core 102, and FIG. 20 is a graph showing a variation of the resonance frequency according to the pressure applied to the core 102 in each of FIGS. 19A and 19B.

FIG. 19A is a view illustrating a state in which the stepped portion 102T of the core 102 is offset toward the magnetic body 140 due to the assembly deviation occurring during the assembly process, and FIG. 19B is a view illustrating a state in which the stepped portion 102T of the core 102 is offset towards the inductor unit 120 due to the assembly deviation.

In a graph of FIG. 20, line ① corresponds to FIG. 16 that is a case without the assembly deviation, line ② corresponds to FIG. 19A; and line ③ corresponds to FIG. 19B.

Referring to FIG. 20, the stylus pen including the first elastic member 180' according to another embodiment of the present invention exhibits a minimal performance change in comparison with the case without the assembly deviation although the assembly deviation slightly occurs in the core 102. Thus, the stylus pen has an advantageous aspect in mass production in comparison with the stylus pen 100 in FIG. 1.

Also, since the stylus pen 100' in FIGS. 15 to 18 does not use components such as the jumping capacitor 215, the ring terminal 161, and the connection terminals 165a and 165b in the stylus pen 100 illustrated in FIGS. 1 to 9, the stylus pen may have a simplified structure and a reduced manufacturing cost. Furthermore, components for arranging the connection terminals 165a and 165b, such as the groove 194 of the second fixing member 190 in FIGS. 7A and 7B and a portion of the first groove 177 of the moving member 170 in FIG. 6, are not required.

Although not shown in the drawing, the stylus pen according to another embodiment of the present invention may be configured such that the first elastic member 180 in the stylus pen 100 in FIG. 2 is replaced with the first elastic member 180' in FIGS. 16 and 17.

Features, structures, and effects described in the above embodiments are incorporated into at least one embodiment of the present disclosure, but are not limited to only one embodiment. Moreover, features, structures, and effects exemplified in one embodiment can easily be combined and modified for another embodiment by those skilled in the art. Therefore, these combinations and modifications should be construed as falling within the scope of the present disclosure. Moreover, features, structures, and effects exemplified in one embodiment can easily be combined and modified for another embodiment by those skilled in the art. Therefore, these combinations and modifications should be construed as falling within the scope of the present invention.

Although embodiments have been described with reference to a number of illustrative embodiments thereof, it should be understood that numerous other modifications and embodiments can be devised by those skilled in the art that will fall within the spirit and scope of the principles of this disclosure. More particularly, various variations and modifications are possible in the component parts and/or arrangements of the subject combination arrangement within the scope of the disclosure, the drawings and the appended claims. In addition to variations and modifications in the component parts and/or arrangements, alternative uses will also be apparent to those skilled in the art.

[Description of reference numerals]

    100, 100': Stylus pen
    101: Housing
    102: Core
    110: Inner case
    115: Guide part
    120: Inductor unit
    130: First fixing member
    190: Second fixing member
    140: Magnetic body
    150: Cover part
    155: Elastic body
    161: Ring terminal
    165a, 165b: Connection terminal
    170: Moving member
    180, 180': First elastic member
    185: Second elastic member
    210, 210': Substrate

**Claims**

1. A stylus pen comprising:

   an inductor unit;
   a first elastic member spaced apart from the inductor unit;
   a core that passes through the inductor unit and moves toward the first elastic member by an external force acting on one end thereof; and
   a magnetic body disposed between the inductor unit and the first elastic member, wherein a distance between the magnetic body and the inductor unit is varied based on a movement of the core,
   wherein the first elastic member is compressed by the movement of the core.

2. The stylus pen of claim 1, wherein the first elastic member is a spring.

3. The stylus pen of claim 2, wherein the first elastic member is disposed in a state in which at least a portion thereof is compressed.

4. The stylus pen of claim 2, further comprising a second elastic member that surrounds a portion of the first elastic member and is compressed by the movement of the core,
   wherein the second elastic member is made of a rubber material or is a spring.

**5.** The stylus pen of claim 1, wherein the first elastic member is made of a rubber material.

**6.** The stylus pen of claim 5, further comprising a second elastic member that surrounds a portion of the first elastic member and is compressed by the movement of the core,

wherein the second elastic member is made of the rubber material that is relatively harder than that of the first elastic member.

**7.** The stylus pen of any one of claims 1 to 6, further comprising:

a housing in which the inductor unit, the first elastic member, the magnetic body, and the rest portion of the core except for one end thereof are disposed;
a first fixing member fixed in the housing;
a second fixing member spaced a predetermined distance from the first fixing member in the housing; and
a moving member that moves between the first fixing member and the second fixing member based on the movement of the core,
wherein the first elastic member is fixed in the second fixing member and compressed by the moving member that moves toward the second fixing member.

**8.** The stylus pen of claim 7, wherein the first fixing member comprises:

a first cavity in which the magnetic body is disposed;
a second cavity in which a portion of the inductor unit is disposed; and
a partition wall disposed between the first cavity and the second cavity and having a through-hole through which the core passes,
wherein the through-hole of the partition wall has a diameter greater than that of a through-hole of the magnetic body.

**9.** The stylus pen of claim 7, wherein the core has a stepped portion disposed between the one end and the other end thereof,

the one end of the core has a thickness greater than that of the other end of the core based on the stepped portion, and
each of a through-hole of the inductor unit and a through-hole of the first fixing member has a diameter greater than that of the through-hole of the magnetic body.

**10.** The stylus pen of claim 9, wherein a distance between the magnetic body and the inductor unit increases as the stepped portion pushes one surface of the magnetic body by an external force applied to the one end of the core.

**11.** The stylus pen of claim 7, further comprising an inner case disposed in the housing to surround the inductor unit, the first fixing member, the moving member, and the second fixing member,

wherein each of the first fixing member and the second fixing member comprises at least one first protrusion that protrudes from an outer surface thereof, and
the inner case comprises a first opening in which the first protrusions of the first fixing member and the second fixing member are disposed.

**12.** The stylus pen of claim 11, wherein the first opening comprises:

a base groove extending in a longitudinal direction of the inner case; and
a plurality of extension grooves connected to the base groove and extending in a direction perpendicular to the longitudinal direction of the base groove,
wherein the plurality of extension grooves are defined at positions corresponding to the first protrusions of the first fixing member and the second fixing member.

**13.** The stylus pen of claim 7, wherein the first fixing member has at least one first groove defined in an outer surface thereof,

the moving member comprises at least one extension portion disposed in the first groove and has at least one first groove and at least one second groove defined in an outer surface thereof, and
the second fixing member comprises a first extension portion and a second extension portion disposed in the first groove and the second groove of the moving member, respectively,
wherein when the moving member moves, the extension portion of the moving member moves in the first groove of the first fixing member, and the first and second extension portions of the second fixing member are disposed in the first and second grooves of the moving member, respectively.

**14.** The stylus pen of claim 7, wherein the second elastic member has a groove,

the moving member has a first groove, and
the second fixing member comprises a first extension portion disposed in the groove of the second elastic member and the first groove of the moving member.

**15.** The stylus pen of claim 7, further comprising:

a capacitor unit comprising a base capacitor electrically connected to the inductor unit and a jumping capacitor that is electrically short-circuited or opened with the base capacitor; a substrate on which the capacitor unit is mounted; a ring terminal disposed on a surface of the moving member between the moving member and the first fixing member to move based on the movement of the moving member; and a connection terminal disposed on a side surface of each of the moving member and the second fixing member and having one end in contact with the ring terminal and the other end connected to a connection pad of the substrate, wherein when the moving member moves and the ring terminal is separated from the one end of the connection terminal, the base capacitor and the jumping capacitor are electrically opened from each other.

**16.** The stylus pen of claim 15, wherein a groove in which the connection terminal is disposed is defined in the side surface of each of the moving member and the second fixing member.

**17.** The stylus pen of any one of claims 1 to 6, wherein a distance between the magnetic body and the inductor unit is varied by the movement of the core,

an inductance value of the inductor unit is varied based on a variation of the distance, and a resonance frequency of a signal emitted to the outside is varied based on a variation of the inductance value.

**18.** The stylus pen of claim 7, further comprising:

a cover part disposed between the other end of the core and the moving member; and an elastic member disposed between the cover part and the magnetic body.

FIG. 1

FIG. 2

FIG. 3A

FIG. 3B

FIG. 4

FIG. 5A

FIG. 5B

FIG. 6A

FIG. 6B

FIG. 7A

FIG. 7B

FIG. 8

FIG. 9A

FIG. 9B

FIG. 10A

FIG. 10B

FIG. 10C

LC

Th | Tp

Tc

FIG. 11A

Vpen

Hover

Contact

Pressure

Freq[Hz]

FIG. 11B

FIG. 12A

165a   161   140

123 ⎫
121 ⎬ 120
102T
102

FIG. 12B

140

123 ⎫
121 ⎬ 120
102T
102

FIG. 12C

140

123 ⎫
121 ⎬ 120
102T
102

Performance based on tolerance of tip

(a) ——— No deviation
(b) ——— Deviation occurs so that L is pressed first
(c) ——— Deviation occurs so that L is pressed later

FIG. 13

FIG. 14A

165a2    165a    161    165a1    211a

FIG. 14B

165a2    165a    161    165a1    211a

FIG. 14C

165a2    165a    161    165a1    211a

FIG. 15

FIG. 16

FIG. 17A

FIG. 17B

FIG. 18A

FIG. 18B

FIG. 18C

FIG. 19A

102T
102

FIG. 19B

102T
102

EP 4 647 879 A2

FIG. 20